# EUROPEAN PATENT APPLICATION

(11) **EP 2 607 317 A1**
(43) Date of publication of application: **26.06.2013**
(21) Application number: 12790319.3
(22) Date of filing: 23.05.2012
(51) Int. Cl.: C01G 1/00, C01G 3/00, C30B 29/22, H01B 12/06, H01B 13/00

(54) **OXIDE SUPERCONDUCTING THIN FILM**

(30) Priority: 23.05.2011 JP 2011114927; 23.05.2011 JP 2011114926
(71) Applicant: Furukawa Electric Co., Ltd., Chiyoda-ku Tokyo 100-8322 (JP)
(72) Inventor: NAKAO, Kengo, Tokyo 100-8322 (JP); SASAKI, Hirokazu, Tokyo 100-8322 (JP); KASAHARA, Hajime, Tokyo 100-8322 (JP); MATSUI, Masakazu, Tokyo 100-8322 (JP)
(74) Representative: Horn Kleimann Waitzhofer
(86) International application number: PCT/JP2012/063231
(87) International publication number: WO 2012/161233

(57) **Abstract**

Provided are favorable critical current properties while inhibiting increase in the number of types of raw materials. Also provided are favorable critical current properties with a single layer.

A superconducting layer containing a plurality of RE-based superconductor units including a rare earth element, CuO chains, and CuO₂ planes; among the CuO chains, CuO chains that are present in the RE-based superconductor units in the vicinity of an interface between the superconducting layer and a layer adjacent to the base material side of the superconducting layer, and that are from 1.2 to 2 times longer in a layering direction than a length of the CuO chains determined according to a lattice constant of the RE-based superconductor units; and an edge dislocation that is present adjacent to the long CuO chain with respect to the layering direction are included. Alternatively, the RE-based superconductor includes CuO₂ planes, CuO single chains and CuO double chains, and further includes a heterologous chain portion in which a CuO single chain and a CuO double chain are adjacent, and a homologous chain portion in which the CuO single chains are adjacent to each other or the CuO double chains are adjacent to each other.

## Description

### Technical Field

The present invention relates to an oxide superconducting thin film.

### Background Art

Conventionally, examples of a technique for putting an oxide superconducting material into practical use include a method for obtaining an oxide superconducting thin film by preparing a base material and depositing an oxide superconductor on the base material.

For an oxide superconductor to be deposited, for example, an RE-based superconductor (RE: rare earth element) which exhibits superconductivity at the liquid nitrogen temperature (77K) or higher, in particular, an RE-based superconductor represented by the composition formula of REBa₂Cu₃O_{7-δ} (hereinafter, simply referred to as "(RE)BCO") is usually used.

An oxide superconducting thin film using such an RE-based superconductor is expected to be applied for superconducting fault current limiter or cable and an SMES (superconducting magnetic energy storage). An RE-based superconductor and the manufacturing method thereof draw a lot of attention.

However, examples of the cause of obstacles to put the oxide superconducting thin film, including the RE-based superconductor, into practical use include that it is not easy to improve the critical current properties (hereinafter, simply referred to as "Ic properties").
While the Ic properties is represented by a product of the critical current density properties (hereinafter, simply referred to as "Jc properties"), the width of the film and the thickness of the film, the Jc properties depend on the state of the oxide superconductor (crystal orientation or the like), and the limit of the film thickness is determined by the thermal stress caused by the difference of the thermal coefficients of the base material and the oxide superconductor.

Accordingly, Patent Document 1 (Japanese Patent Application Laid-Open (JP-A) No. 2008-140789) discloses that, by depositing an (RE)BCO thin film not having a single layer structure but having a multilayer structure including an intermediate layer thin film in-between different from the (RE)BCO thin film without introducing an appropriate amount of void, the thermal stress caused by the difference between the thermal coefficients of the base material and the oxide superconductor is alleviated and the limit of the film thickness is extended, thereby improving the Ic properties.

Generally, the oxide superconducting thin film which employs a pure RE-based superconductor and is deposited to have a favorable crystal orientation exhibits high critical current properties under no magnetic field. However, the pure RE-based superconductor has a problem that the critical current properties decrease drastically under high magnetic field.
As a countermeasure to the problem, attempts to introduce a pinning center which pins a magnetic flux in an oxide superconducting thin film are being made.

As a method of improving the critical current density, for example, Patent Document 2 (JP-A-63-318014) discloses a method of making, by alternately stacking plural RE-123 based superconducting layers and ferromagnetic metal layers, the ferromagnetic metal layers function as pinning centers.
Patent Document 3 (JP-A No. 2005-116408) discloses forming of a thin film whose critical current properties do not deteriorate even when the thickness of the film becomes large and whose critical current value in a magnetic field is high by depositing in different conditions of oxygen partial pressures and/or temperatures to stack plural oxide superconducting layers having different amounts of stacking faults.
Patent Document 4 (JP-A No. 2009-283372) discloses that, by employing, as an oxide superconducting layer, a stack of a first superconducting film of an RE-123 based superconducting material not containing impurities and a second superconducting film of an RE-123 based superconducting material containing impurities which stack has a structure at least having an interface between the first superconducting film and the second superconducting film, a crystal grain boundary due to lattice mismatch or the like in the interface as well as an impurity phase in the second superconducting film functions as a pinning center, whereby the critical current density under a magnetic field can be improved.

### DISCLOSURE OF INVENTION

### Technical Problem

By employing the configuration of Patent Document 1, however, a superconducting layer has a structure having an (RE)BCO thin film and an intermediate layer thin film which selects an RE' different from that of the (RE)BCO thin film, resulting in increase in the number of types of raw materials, which may lead to high cost.

In the configurations of Patent Documents 2 to 4, it is assumed that plural oxide superconducting films be stacked.

The present invention has been made in view of the circumstances, and it is an object of the present invention to provide an oxide superconducting thin film having favorable critical current properties while inhibiting increase in the number of types of raw materials.
Another object of the present invention is to provide an oxide superconducting thin film having favorable critical current properties with a single layer.

### Solution to Problem

The above-described problems were solved by the following means.
<1> An oxide superconducting thin film, comprising:
   a base material;
   a superconducting layer formed on the base material and comprising a plurality of RE-based superconductor units comprising a rare earth element, CuO chains, and CuO₂ planes;
   among the CuO chains, CuO chains that are present in the RE-based superconductor units in the vicinity of an interface between the superconducting layer and a layer adjacent to the base material side of the superconducting layer, and that are from 1.2 to 2 times longer in a layering direction than a length of the CuO chains determined according to a lattice constant of the RE-based superconductor units; and
   an edge dislocation that is present adjacent to the long CuO chain with respect to the layering direction.
   It is noted that "a layer adjacent to the base material side" includes not only an intermediate layer but also the base material itself.

<2> The oxide superconducting thin film according to <1>, comprising an intermediate layer that is disposed between the base material and the superconducting layer and that comprises another rare earth element capable of having the same valence as the rare earth element.

<3> The oxide superconducting thin film according to <1> or <2>, wherein the long CuO chains are present in the RE-based superconductor units that are in a first layer or a second layer from the interface between the superconducting layer and the layer adjacent to the base material side of the superconducting layer.

<4> The oxide superconducting thin film according to <3>, wherein the RE-based superconductor unit in the first layer is layered from the rare earth element.

<5> The oxide superconducting thin film according to any one of <2> to <4>, wherein the RE-based superconductor units sandwiching the long CuO chain in the layering direction are displaced from each other in an ab plane direction by 1/8 to 1/2 of the RE-based superconductor unit.

<6> The oxide superconducting thin film according to any one of <2> to <5>, wherein at least a layer on the superconducting layer side in the intermediate layer is formed of CeO₂ or REMnO₃.

<7> An oxide superconducting thin film formed on a base material and comprising an RE-based superconductor as a main component,
wherein the RE-based superconductor comprises CuO₂ planes, CuO single chains and CuO double chains, and further comprises a heterologous chain portion in which a CuO single chain and a CuO double chain are adjacent, and a homologous chain portion in which the CuO single chains are adjacent to each other or the CuO double chains are adjacent to each other.

<8> The oxide superconducting thin film according to <7>, wherein the heterologous chain portion is 1/4 times to 4 times the homologous chain portion.

<9> The oxide superconducting thin film according to <7> or <8>, wherein an oxygen ion of a CuO₂ plane adjacent to the CuO single chain and the CuO double chain is positioned so as to be shifted from a mid-point between nearest neighboring Cu's on the adjacent CuO₂ plane by 1/8 to less than 1/2 of one unit cell of the RE-based superconductor in an ab plane direction of the RE-based superconductor.

<10> The oxide superconducting thin film according to any one of <7> to <9>, comprising a structure in which the heterologous chain portion and the homologous chain portion are present in a mixed manner in a c-axis direction of the RE-based superconductor.

<11> The oxide superconducting thin film according to any one of <7> to <10>, comprising a modulated structure having a modulated layer in which the heterologous chain portion and the homologous chain portion are present in a mixed manner in the ab plane direction of the RE-based superconductor.

### Effects of the Invention

According to the present invention, an oxide superconducting thin film which has favorable critical current properties while suppressing increase of the number of types of raw materials may be provided.
Further, according to the present invention, an oxide superconducting thin film which has favorable critical current properties even when it is a single layer may be provided.

### BRIEF DESCRIPTION OF DRAWINGS

Fig. 1 is a diagram showing a layered structure of an oxide superconducting thin film according to an embodiment of the present invention.
Fig. 2 is a diagram showing a crystal structure according to a first embodiment of an RE-based superconductor which configures a superconducting layer shown in Fig. 1.
Fig. 3 is a diagram showing a crystal structure according to a second embodiment of an RE-based superconductor which configures a superconducting layer shown in Fig. 1.
Fig. 4 is a diagram schematically illustrating a superconducting fault current limiter according to an embodiment of the present invention.
Fig. 5 is a diagram showing an ABF image of, in particular, the interface between an intermediate layer (CeO₂ layer) and a superconducting layer (YBCO layer) in a cross-section in the layering direction P of an oxide superconducting thin film of a thin-film type superconducting element according to Example 1.
Fig. 6 is a diagram showing another ABF image of, in particular, the interface between an intermediate layer (CeO₂ layer) and a superconducting layer (YBCO layer) in a cross-section in the layering direction P of an oxide superconducting thin film of a thin-film type superconducting element according to Example 1, which is at a position different from that in Fig. 5.
Fig. 7 is a diagram showing an ABF image of a partial region of a superconducting layer in a thin-film type superconducting element of Example 2.
Fig. 8 is a diagram showing an ABF image of another partial region of a superconducting layer in a thin-film type superconducting element of Example 2.
Fig. 9 is a diagram showing an ABF image of another partial region of a superconducting layer in a thin-film type superconducting element of Example 2.

### BEST MODE FOR CARRYING OUT THE INVENTION

Hereinafter, the oxide superconducting thin film according to embodiments of the present invention will be concretely described with reference to the attached drawings. In the drawings, members (components) having the same or corresponding functions are denoted by the same reference numeral, and explanation thereof will be properly omitted.

### <Configuration of an oxide superconducting thin film>

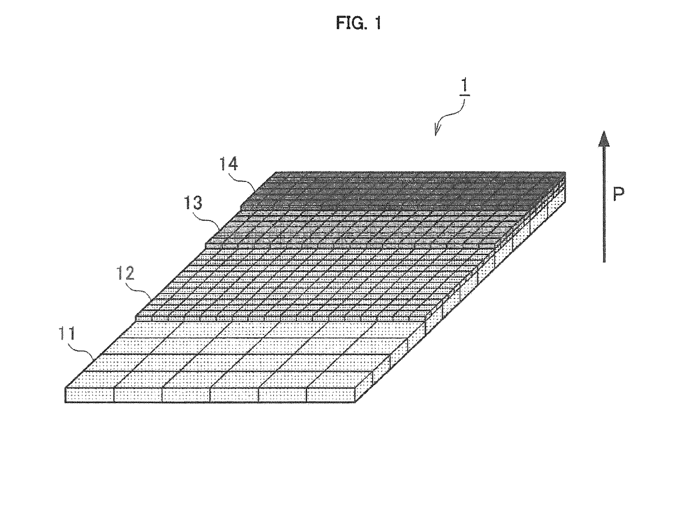

Fig. 1 is a diagram showing a layered structure of an oxide superconducting thin film 1 according to an embodiment of the present invention.
As shown in Fig. 1, the oxide superconducting thin film 1 has a layered structure in which an intermediate layer 12, a superconducting layer 13 and a stabilizing layer (protecting layer) 14 are formed on a base material 11 sequentially in the layering direction P.

A low magnetic metal base material or a ceramics base material is employed for the base material 11. The shape of the base material 11 is not specifically limited as long as it has a main surface, and a variety of shapes of materials such as a plate, a wire rod and a strip can be employed. For example, by using a tape-shaped base material, an oxide superconducting thin film 1 can be applied as a superconducting wire rod.
Metals such as Cr, Cu, Ni, Ti, Mo, Nb, Ta, W, Mn, Fe or Ag or alloys thereof having an excellent strength and heat resistance can be used as the metal base material. A particularly preferable metal base material is stainless, HASTELLOY (registered trademark) and other nickel based alloys, which have an excellent corrosion resistance and heat resistance. On such a variety of metal materials, a variety of ceramics may be disposed. MgO, SrTiO₃ or yttrium-stabilized zirconia, sapphire or the like can be employed as the ceramics base material.
The thickness of the base material 11 is not specifically limited, and for example, it is 1 mm.

The intermediate layer 12 is formed on one main surface of the base material 11 in order to realize a high in-plane orientation in the superconducting layer 13, and is a layer which is adjacent to the base material 11 side of the superconducting layer 13. The intermediate layer 12 may be configured by a single layer film or a multi-layer film. This intermediate layer 12 is not specifically limited, but, at least the outermost layer (a layer on the superconducting layer 13 side) is of a material selected from CeO₂ and REMnO₃, and is preferably CeO₂. The valence of Ce is usually 4 and may be 3.
The film thickness of the intermediate layer 12 is not specifically limited, and for example, it is 20 nm.

The superconducting layer 13 is formed on the intermediate layer 12 and contains an RE-based superconductor as a main component. The term "main component" means that the main component has the largest content in the components contained in the superconducting layer 13, and preferably has a content of higher than 90%. Representative examples of the RE-based superconductor include REBa₂Cu₃O_{7-δ} (RE-123), REBa₂Cu₄O₈ (RE-124) and RE₂Ba₄Cu₇O_{15-δ} (RE-247). Any of these have a lamellar perovskite structure, and its inner structure is divided into a portion in which RE, Ba and Cu and oxygen have a perovskite structure and a portion in which Cu and oxygen are bonded each other in a chain shape. The perovskite structure portion has a CuO₂ plane in its structure and is known as beinga portion through which a supercurrent flows. The CuO chain portion has a CuO single chain in which every CuO is in a single chain and a CuO double chain in which CuOs are in a double. A structure in which every CuO chain is a single chain is referred to as RE-123, a structure in which a single chain and a double chain exist alternatively is referred to as RE-247, and a structure in which every CuO is a double chain is referred to as RE-124.

The RE(s) is/are a single rare earth element or plural rare earth elements such as Y, Nd, Sm, Eu, Gd, Dy, Ho, Er, Tm, Yb and/or Lu. RE is preferably Y among these for the reason that hardly causes substituttion for a Ba site or other reasons. δ is an oxygen non-stoichiometric amount which is, for example, 0 to 1. From the viewpoint of a high superconducting transition temperature, the value of the oxygen non-stoichiometric amount nearer to 0 is preferable. The oxygen non-stoichiometric amount δ may be less than 0, i.e., a negative value when high-pressure oxygen annealing or the like is performed by using an apparatus such as an autoclave.
The film thickness of the superconducting layer 13 is not specifically limited, and for example, 200 nm.

The stabilizing layer 14 is formed on the superconducting layer 13, and is configured by silver or the like. The film thickness of the stabilizing layer 14 is not specifically limited, and for example, 200 nm.

### <First embodiment>

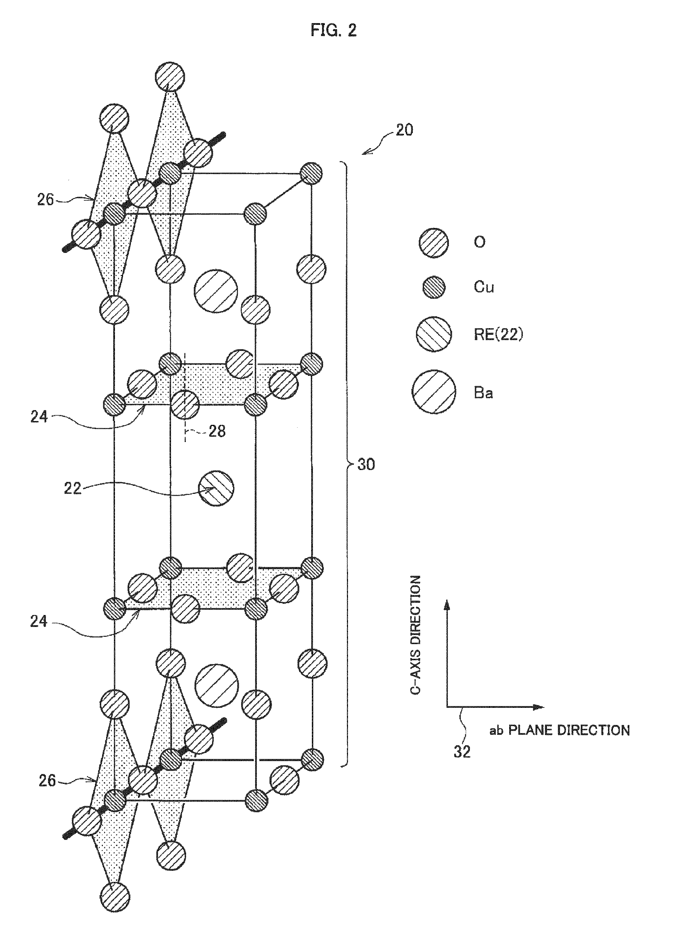

Fig. 2 is a diagram showing a crystal structure according to a first embodiment of an RE-based superconductor 20 configuring the superconducting layer 13 shown in Fig. 1. The crystal structure shown in Fig. 2 as a whole indicates a unit lattice (unit cell) of an RE-123. The RE-based superconductor 20 of the first embodiment is not limited to one that is configured only by RE-123, but also encompasses one in that RE-123, RE-124 and/or RE-247 are present in a mixed manner and the crystal structure represented by the overall diagram configures a part of the unit lattice of the RE-based superconductor 20.

The RE-based superconductor 20, as shown in Fig. 2, includes, in the unit lattice, CuO₂ planes 24 positioned on the both sides in a c-axis direction of a rare earth element (RE) 22 and a CuO single chain 26 positioned outside in the c-axis direction from the CuO₂ plane 24 with respect to the rare earth element 22. In the present embodiment, a unit lattice of the RE-based superconductor 20 is referred to as an "RE-based superconductor unit 30". Although, in the "RE-based superconductor unit 30", the CuO₂ plane is in the bottom layer of the unit in Fig. 2, a unit may be formed by setting the rare earth element 22 in the bottom layer.
The superconducting layer 13 is configured by containing the plural RE-based superconductor units 30 (in the layering direction P as well as in the width direction), and includes among the plural CuO single chains 26 in the superconducting layer 13, a CuO single chain that is present in the RE-based superconductor unit 30 in the vicinity of an interface between the superconducting layer 13 and an intermediate layer 12 and which is from 1.2 to 2 times longer in the layering direction P than a length of the CuO single chain determined by a lattice constant of the RE-based superconductor unit 30; and an edge dislocation that is present adjacent to the long CuO single chain in the layering direction P. Here, the reason why the length of the long CuO single chain in the layering direction P is 1.2 times or more the length of the CuO single chain determined by the lattice constant of the RE-based superconductor unit 30 is that it is considered that the interaction in the c-axis direction is smaller than the interactions in the a-axis direction and the b-axis direction. The reason why the length of the long CuO single chain in the layering direction P is 2 times or less the length of the CuO single chain determined by the lattice constant of the RE-based superconductor unit 30 is to inhibit deterioration of the orientation of the superconducting layer 13.
In the case of RE-124 or RE-247, the CuO chain longer in the layering direction may be a double chain not a single chain. In this case, the length of the long double chain is 1.2 times to 2 times longer in the layering direction P than the length of the CuO double chain determined by the lattice constant of the RE-based superconductor unit 30.

In such a manner, the presence of the CuO single chain extending in the layering direction P in the RE-based superconductor unit that is present in the vicinity of the interface between the superconducting layer 13 and the intermediate layer 12 can inhibit the influence of the structure of the intermediate layer 12 on the RE-based superconductor unit 30 present on the opposite side of the intermediate layer 12 with respect to the long CuO single chain in the layering direction P, and can alleviate the lattice strain of the intermediate layer 12 and the superconducting layer 13. As a result, a structure is obtained that is unlikely to crack due to thermal shrinkage, thereby enabling thickening of the film. The lattice constant of CeO₂ is smaller than that of YBCO and, therefore, when the number of lattices of YBCO is smaller than the number of lattices of CeO₂, the strain becomes smaller. Consequently, when there is an edge dislocation adjacent to the long CuO single chain in the layering direction P, the number of lattices of YBCO of the superconducting layer 13 is smaller than the number of lattices of, for example, CeO₂ of the intermediate layer 12, whereby the lattice mismatch of the intermediate layer 12 and the superconducting layer 13 is alleviated. As a result, a structure is obtained that is unlikely to crack due to thermal shrinkage, thereby enabling thickening of the film.
When it becomes possible to make the film thicker in this way, the Ic properties, which are represented by the product of the Jc properties, the film thickness and the width, can be improved. Further, since there is no need to configure the superconductor layer with an (RE)BCO thin film and a thin film in which an RE' different from that in the (RE)BCO thin film is selected as in Patent Document 1, an oxide superconducting thin film 1 having favorable Ic properties can be provided without increasing the number of types of raw materials for forming the superconductor layer.
The "length of the CuO single chain determined by the lattice constant of the RE-based superconductor unit 30" can be determined by using the ratio of the lattice constant of the superconductor and the length of the CuO single chain, with respect to the lattice constant of the RE-based superconductor unit 30 determined by an X-ray diffraction measurement.
The "vicinity of the interface" means a region within five RE-based superconductor units 30 from the interface of the superconducting layer 13 and the intermediate layer 12, and preferably indicates presence in the RE-based superconductor unit 30 in a first layer or a second layer from the interface of the superconducting layer 13 and the intermediate layer 12, from the viewpoint of alleviating the lattice mismatch of the overall superconducting layer 13 from the bottom layer of the superconducting layer 13. The "edge dislocation adjacent to the long CuO single chain in the layering direction P" means an edge dislocation present in the RE-based superconductor units 30 in a range of from the first layer to the third layer with respect to the long CuO single chain. The edge dislocation preferably exists in the RE-based superconductor unit 30 of the first layer, but it is also possible effect its presence in the RE-based superconductor units 30 of up to the third layer by imparting the intermediate layer 12 with irregular configuration.

Still further, since the intermediate layer (CeO₂) and the RE in the RE-based superconductor unit 30 have good binding properties, when these are layered, a strain energy due to the lattice mismatch of CeO₂ and YBCO concentrates on the CuO single chain in the RE-based superconductor unit 30 in the vicinity of the interface between the superconducting layer 13 and the intermediate layer 12, and the CuO single chain extends to alleviate the strain, a long CuO single chain can easily be made. For this reason, the RE-based superconductor unit 30 of the first layer is preferably layered such that the rare earth element 22 is the bottom layer. In order to attain this, there is a need to promote solid solution at the interface by matching the valence of the Ce atom in the intermediate layer and the valence of the rare earth element 22 of the RE-based superconductor unit 30. For example, it is considered that, by sintering the superconducting layer 13 and the intermediate layer 12 in an inert atmosphere to reduce the valence of other rare earth elements in particular on the surface of the intermediate layer 12 such that, for example, the valence of Ce of CeO₂ is changed from 4 to 3, the rare earth element 22 (whose valence is assumed to be 3) of the RE-based superconductor unit 30 of the first layer in the superconducting layer 13 is strongly bonded to the site of other rare earth element on the surface of the superconducting layer 13.
The oxygen ion on the CuO₂ plane 24 of the RE-based superconductor unit 30 of the above-mentioned first layer is preferably positioned so as to be shifted from a half unit cell position 28 (see Fig. 2, in particular, the mid-point between the nearest neighboring Cu's on the adjacent CuO₂ plane) of the RE-based superconductor unit 30 by 1/8 to 1/2 in the ab plane direction 32. When the oxygen ion is positioned so as to be shifted in the ab plane direction 32, the oxide superconducting thin film 1 having favorable Ic properties can be obtained. It is considered that the favorable Ic properties are obtained because the portion of the RE-based superconductor unit 30 where the position of the oxygen ion on the CuO₂ plane 24 is shifted is a pinning center.
From the viewpoint of weakening the bond between lattices to make it easy to introduce an edge dislocation, it is preferable that the RE-based superconductor units 30 sandwiching the long CuO chain in the layering direction P shift each other by 1/8 to 1/2 of the RE-based superconductor unit 30 in the ab plane direction 32.

From the viewpoint of alleviating the lattice mismatch, it is preferable that the number of the above-mentioned edge dislocations be a number which matches the ratio of the lattice constant in the superconducting layer 13. For example, when the intermediate layer 12 is formed of CeO₂ and the superconducting layer 13 is formed of YBCO, since the lattice constant of b-axis of YBCO is 3.89 Å (a-axis is 3.81 Å) while the interval of Ce of CeO₂ is 3.83 Å (the lattice constant is 5.41 Å), it is preferable that CeO₂ : YBCO = 65 : 64. Namely, it is preferable that about one dislocation be seen per 70 lattices.
While it has been described that the above-mentioned long CuO single chain becomes 1.2 or more times longer, it is preferable that the length thereof be 1.8 or more times longer than the length of the CuO single chain determined by the lattice constant of the RE-based superconductor unit 30. Since the interaction between atoms rapidly decrease when the atoms depart from each other, i.e., the strength of the interaction is determined in accordance with the square of the distance, when the distance becomes up to about twice, the interaction is considered to decrease to about 1/4. Accordingly, when the CuO single chain becomes long, the interactions between the long CuO single chain and the lattices thereabove and therebelow become small. When the interactions between the long CuO single chain and the lattices thereabove and therebelow become weak, the superconductor is less likely to be affected by the lattice constant of the lower layer, whereby an edge dislocation is considered to be likely to be generated. It is noted that when the length of the CuO single chain becomes over twice, the interaction decreases too much and the orientation of the superconducting layer 13 deteriorates.
Regarding the relationship between the length of the CuO single chain and the dislocation, since the RE-based superconductor 20 is an ionic crystal, when there is a defect such as an edge dislocation, intrinsically, a compulsive force is exerted which makes the crystal partially unstable. It is thought, however, that, by the presence of such a long CuO single chain in the first embodiment, even when a lattice defect is generated at that site, the compulsive force becomes smaller than the usual state, and as the result a defect is likely to be generated.

In order to attain the above-mentioned configuration, the manufacturing method is appropriately adjusted, for example, by annealing the intermediate layer 12 in the air at 800°C or higher, or by forming or annealing the superconducting layer 13 in an inert atmosphere in the temperature range between 700°C and 900°C.
The determination of the position of an oxygen ion can be performed by using an ABF-STEM (angle-controlled annular bright-field scanning transmission electron microscopy) by a Transmission Electron Microscope (TEM: Transmission Electron Microscope). By the ABF image obtained by the ABF-STEM, a light element such as oxygen can be detected by imaging an electron scattered in a small scattering angle by using an annular detector.

### <Second embodiment>

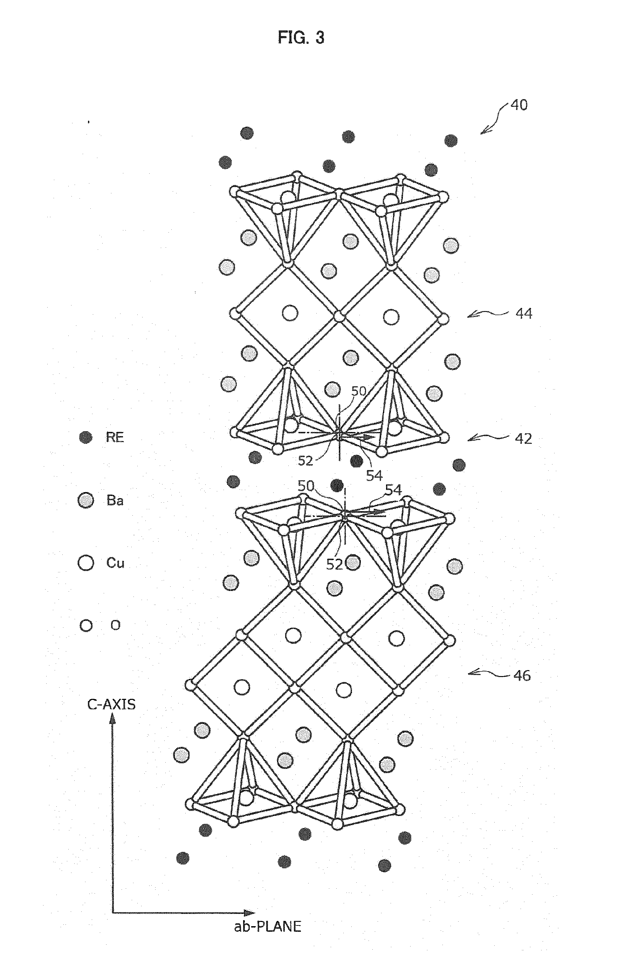

Fig. 3 is a diagram showing a crystal structure according to a second embodiment of an RE-based superconductor 40 configuring the superconducting layer 13 shown in Fig. 1. The crystal structure shown in Fig. 3 as a whole indicates a unit lattice (unit cell) of an RE-247. The RE-based superconductor 40 of this embodiment encompasses not only that configured only by RE-247, but also that configured by RE-123, RE-124 and/or RE-247 which are present in a mixed manner and the crystal structure represented by the overall diagram configures a part of the unit lattice of the RE-based superconductor 40.

As shown in Fig. 3, an RE-based superconductor 40 according to an embodiment of the present invention includes a CuO₂ plane 42 positioned on both sides of the RE in a c-axis direction, a CuO single chain 44 positioned between BaO and BaO, and a CuO double chain 46 having two CuO single chains 44 positioned between BaO and BaO.
In order to attain this configuration, the RE-based superconductor 40 is the above-mentioned RE-247. However, since it is difficult to form a single body of RE-247, superconducting layer 13 includes a stacking fault in which a CuO single chain 44 and a CuO double chain 46 occur randomly, and in the region having this stacking fault, the RE-based superconductor 40 forms a superlattice structure which has a CuO₂ plane 42, a heterologous chain portion in which a CuO single chain 44 is adjacent to a CuO double chain 46, and a homologous chain portion in which CuO single chains are adjacent with each other or CuO double chains are adjacent with each other. Namely, the superlattice structure is configured by at least two selected from RE-123, RE-124 and RE-247, and in the region other than the superlattice structure of the superconducting layer 13, the RE-based superconductor 40 is configured by RE-123 or RE-124. A pinning center can be introduced thereto by including a stacking fault in the superconducting layer 13 in such a manner.
The volume of the heterologous chain portion configuring the stacking fault preferably has a volume of from 20% to 80% with respect to the all the chain portions in view of the fact that this portion effectively functions as a pinning center. Namely, the volume of all the heterologous chain portions is preferably 1/4 times to 4 times that of all the homologous chain portions. Pinning centers are preferably introduced at an interval shorter than the coherence length of the RE-based superconductor (YBCO). When the volume of the heterologous chain portion is less than 20%, the interval is not shorter than the coherence length of the RE-based superconductor (YBCO) and, further, when the volume of the heterologous chain portion is larger than 80%, the interval is not shorter than the coherence length of the RE-based superconductor (YBCO), which is not preferable.
Examples of types of the superlattice structure include: a structure in which a CuO single chain 44 and a CuO double chain 46 are simply mixed in the c-axis direction, i.e., a heterologous chain portion and a homologous chain portion are present in a mixed manner in the c-axis direction; and a modulated structure which includes a modulated layer in which a CuO single chain 44 and a CuO double chain 46 are present in a mixed manner in the ab plane direction, i.e., a heterologous chain portion and a homologous chain portion are present in a mixed manner in the ab-axis direction.
In order to ensure that the superlattice structure effectively functions as a pinning center, the superlattice structures are preferably present at a small interval of 1 um or larger in the region of the superconducting layer 13.

In the RE-based superconductor 40 according to an embodiment of the present invention, an oxygen ion 50 on the CuO₂ plane 42 adjacent to the CuO single chain 44 and the CuO double chain 46 is preferably positioned so as to be shifted from a half unit cell position 52 (in particular, the mid-point between the nearest neighboring Cu's in the adjacent CuO₂ plane) by 1/8 to less than 1/2 of one unit cell of the RE-based superconductor 40 in the ab plane direction of the RE-based superconductor. The oxygen ion 50 in the figure is positioned at a half unit cell position 52 for the sake of simplicity of explanation. In such a manner, when the oxygen ion 50 is positioned so as to be shifted by 1/8 to less than 1/2 in the ab plane direction 34, the state of the valence of Cu on the CuO₂ plane 42 changes and a pinning center can be further introduced, thereby obtaining an oxide superconducting thin film 1 having favorable critical current properties with a single layer.
The degree of shift of the oxygen ion 50 in the CuO₂ plane 42 assumes a shift of 1/8 to less than 1/2 of one unit cell of the RE-based superconductor 40 (superlattice structure). The degree of shift is 1/8 or higher because it leads the value of valence of Cu at which an effect as a pinning center is exerted. The degree of shift is less than 1/2 because when it is 1/2, competition with Cu occurs and when it is 1/2 or more, a unit cell which is referred to as a standard is merely changed. The degree of shift of the oxygen ion 50 is preferably 1/4 to less than 1/2 from the viewpoint of functioning as a stronger pinning center.

In particular, when the superlattice structure has a configuration in which the CuO single chain 44 and the CuO double chain 46 are merely mixed in the c-axis direction of the RE-based superconductor 40, the oxygen ion 50 on the CuO₂ plane which is arranged between the CuO single chain 44 and the CuO double chain 46 is positioned so as to be shifted in the ab plane direction.
When the superlattice structure has a modulated structure which has a modulated layer in which the CuO single chain 44 and the CuO double chain 46 are present in a mixed manner in the ab plane direction, the oxygen ions 50 on the CuO₂ planes 42 adjacent to the modulated layer and sandwiching the modulated layer is positioned so as to be shifted in the ab plane direction. Cu which is a part of the CuO₂ plane is also positioned so as to be shifted in the c-axis direction of the RE-based superconductor.
Compared to the case where the oxygen ion 50 on the CuO₂ plane sandwiched between CuO chain and CuO double chain shifts in the c-axis direction, it is preferable that the oxygen ion 50 on the CuO₂ plane sandwiched between the modulated layer and the CuO double chain 46 shifts from the viewpoint that a pin is easy to be introduced in the c-axis direction.

In order to attain the shift of the oxygen ion 50, a variety of schemes are used such as: after annealing the intermediate layer 12, forming the superconducting layer 13; forming the superconducting layer 13 at a high-pressure oxygen atmosphere, preferably at 5 atm or higher; sintering the superconducting layer 13 in an inert atmosphere at 750°C to 850°C, preferably at 780°C to 820°C; or after sintering under argon atmosphere, switching the atmosphere to oxygen atmosphere and lowering the temperature.

The determination of the position of the oxygen ion 50 can be performed by using an ABF-STEM (angle-controlled annular bright-field scanning transmission electron microscopy) by a Transmission Electron Microscope (TEM: Transmission Electron Microscope). By the ABF image obtained by the ABF-STEM, a light element such as oxygen can be detected by imaging an electron scattered in a small scattering angle by using an annular detector.

### <Modifications>

Although the specific embodiments have been described in detail, the present invention is not limited thereto. It will be obvious to those skilled in the art that other various embodiments are possible without departing from the scope of the invention. For example, the above-described plural embodiments may be appropriately combined with each other to implement the invention. In addition, the following modifications may be appropriately combined with each other.

For example, the intermediate layer 12 or the stabilizing layer 14 can be omitted as appropriate. Although the superconducting layer 13 of the oxide superconducting thin film 1 is explained in the case of a single layer, the layer may be a multi-layer. Although, as the RE-based superconductors 20 and 40, REBa₂Cu₃O_{7-δ} has been exemplified, the Ba site may be doped with Ca and the Cu site may be doped with Co.

The disclosures of Japanese Patent Application No. 2011-114926 and Japanese Patent Application No. 2011-114927 are incorporated by reference herein in their entirety.
All the literature, patent applications and technical standards described in the present specification are incorporated by reference herein to the same extent as in cases where each literature, patent application or technical standard is concretely and individually described to be incorporated by reference.

The oxide superconducting thin film 1, that is explained in the embodiment, can be applied to other various equipments. For example, the oxide superconducting thin film 1 can be applied to equipments such as a superconducting fault current limiter, an SMES (Superconducting Magnetic Energy Storage), a superconducting transformer, an NMR (Nuclear Magnetic Resonance) analyzer, a single crystal pulling apparatus, a linear motor car and a magnetic separation apparatus.

### <Superconducting fault current limiter>

Next, the configuration of a superconducting fault current limiter is taken as an example for a case in which the oxide superconducting thin film 1 is applied to the superconducting fault current limiter.

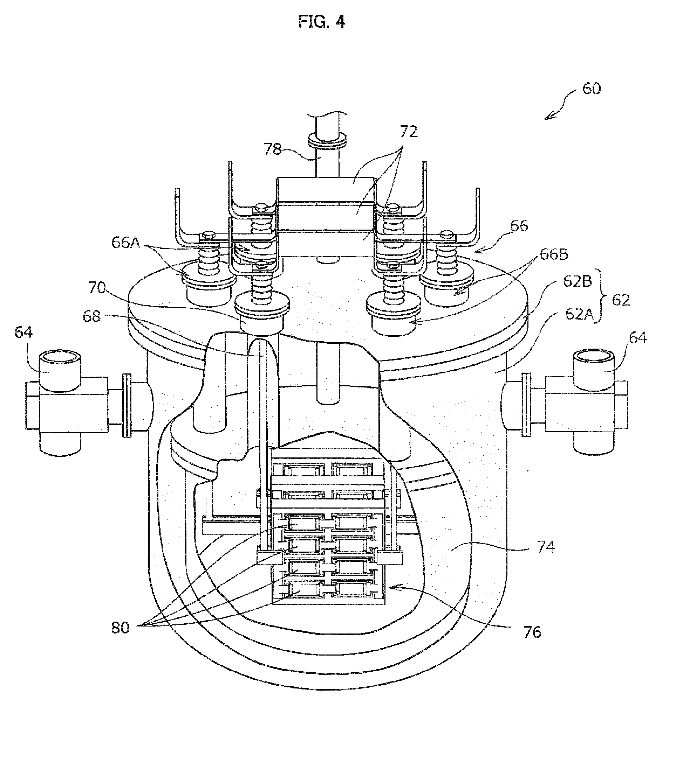

Fig. 4 is a diagram schematically illustrating a superconducting fault current limiter 60 according to an embodiment of the present invention.

The superconducting fault current limiter 60 according to an embodiment of the present invention is an equipment having a function of, by utilizing S/N transition (superconducting-normal state transitions) of the superconductor, exhibiting a zero resistivity at a rated operating condition and exhibiting a high resistivity when an excess current which is higher than the critical current flows, thereby supressing an excess current.

The superconducting fault current limiter 60 is provided with a sealed container 62 which has a container body 62A covered with a lid 62B to be hermetically sealed.
To the container body 62A, a refrigerator 64 is connected, and liquid nitrogen is introduced into the sealed container 62 from the refrigerator 64. To the lid 62B, a current inlet-outlet unit 66, via which an electric current flows in from outside the sealed container 62 to inside the sealed container 62 and flows out, is connected. The current inlet-outlet unit 66 is configured by a three-phase alternating current circuit, and is specifically configured by including three current inlet units 66A and corresponding three current outlet units 66B.

The current inlet unit 66A and the current outlet unit 66B are individually configured by a conducting wire 68 which penetrates the lid 62B and extends in the vertical direction and a tube 70 which covers the conducting wire 68.
One terminus of the conducting wire 68 of the current inlet unit 66A which is exposed outside is connected to the other terminus of the conducting wire 68 of the corresponding current outlet unit 66B via an external resistance 72 as a shunt resistance.

At a terminal portion of each tube 70 inside the container body 62A, an element housing container 74 is supported.
The element housing container 74 is built in the sealed container 62 and the inside thereof is cooled by liquid nitrogen to be filled in the sealed container 62.

A current limiting unit 76 which includes plural thin-film type superconducting elements 80 configured by attaching an electrode to the oxide superconducting thin film 1 is built in the element housing container 74. In an embodiment of the present invention, in particular, three sets of the thin-film type superconducting elements 80 arranged in four rows and two columns configure the current limiting unit 76.
The current limiting unit 76 is supported by the other terminus of the conducting wire 68 of the current inlet unit 66A which resides inside, the other terminus of the conducting wire 68 of the current outlet unit 66B which resides inside, and a supporting column 78. The other terminus of the conducting wire 68 of the current inlet unit 66A which resides inside and the other terminus of the conducting wire 68 of the current outlet unit 66B which resides inside are electrically connected to the current limiting unit 76 via the thin-film type superconducting element 80 such that the three-phase alternating current circuit is configured.

Here, in order to put a superconducting fault current limiter into practical use, it is demanded to flow as large an electric current as possible with zero resistivity, which needs improvement in the critical current properties of the oxide superconducting thin film. Since the oxide superconducting thin film 1 exhibiting favorable critical current properties is applied in the present embodiment as the thin-film type superconducting element 80 of the superconducting fault current limiter 60, a larger electric current can be allowed to flow with zero resistivity, thereby enabling practical use.

### EXAMPLES

Hereinafter, the oxide superconducting thin film according to the present invention will be described with reference to examples. However, the present invention is not limited to the following examples.

In Examples, a thin-film type superconducting element which is used for the superconducting fault current limiter as the oxide superconducting thin film was manufactured.

### -Example 1-

### <Manufacturing of thin-film type superconducting element>

In the manufacturing of a thin-film type superconducting element of Example 1, firstly, a sapphire substrate in which the R-plane of the sapphire single crystal is the main surface was prepared. Next, the sapphire substrate was subjected to pre-annealing at 1000°C and cut in the r-plane direction. Then the cut sapphire substrate was subjected to annealing at 1000°C. Next, in a state in which a plasma was generated in 3 × 10⁻² Pa oxygen and the sapphire substrate was heated up to 700°C or higher, CeO₂ was deposited to be about 10 nm to 40 nm by using EB (electron beam), to form an intermediate layer.
Next, the sapphire substrate on which the intermediate layer was formed was subjected to annealing at 800°C to perform a surface treatment (flattening and regulation of the valence). By this, the crystallinity of CeO₂ is increased, and, as mentioned below, the strain of CeO₂ becomes smaller than conventional arts, whereby lattice relaxation is made to easily occur in YBCO.

Next, a solution of organic complexes of yttrium, barium and copper was coated with a spin coater, and presintering was performed at 500°C in the air. Then, sintering was performed in an inert atmosphere, i.e., in a current of an inert gas at an oxygen partial pressure of about 100 ppm at 800°C, and switched to an oxygen atmosphere along the way. By sintering in an inert atmosphere, the direction of growth of the crystal which forms YBCO was determined, and the lattice relaxation of YBCO can occur at an early stage, whereby a YBCO thin film having good characteristics was obtained.
A gold-silver alloy was deposited on the obtained superconducting thin film with a sputter and an electrode was attached to manufacture a superconducting fault current limiting element. Although the superconducting fault current limiting element was in a superconducting state by cooling to the liquid nitrogen temperature, when a certain amount of electric current flowed, the element was in a normal conducting state, thereby enabling current limiting.

### <TEM evaluation>

The obtained thin-film type superconducting element was processed and, by using a TEM (Transmission Electron Microscope), plural ABF (annular bright-field) images of a cross-section in the layering direction P of the oxide superconducting thin film of the thin-film type superconducting element were observed.

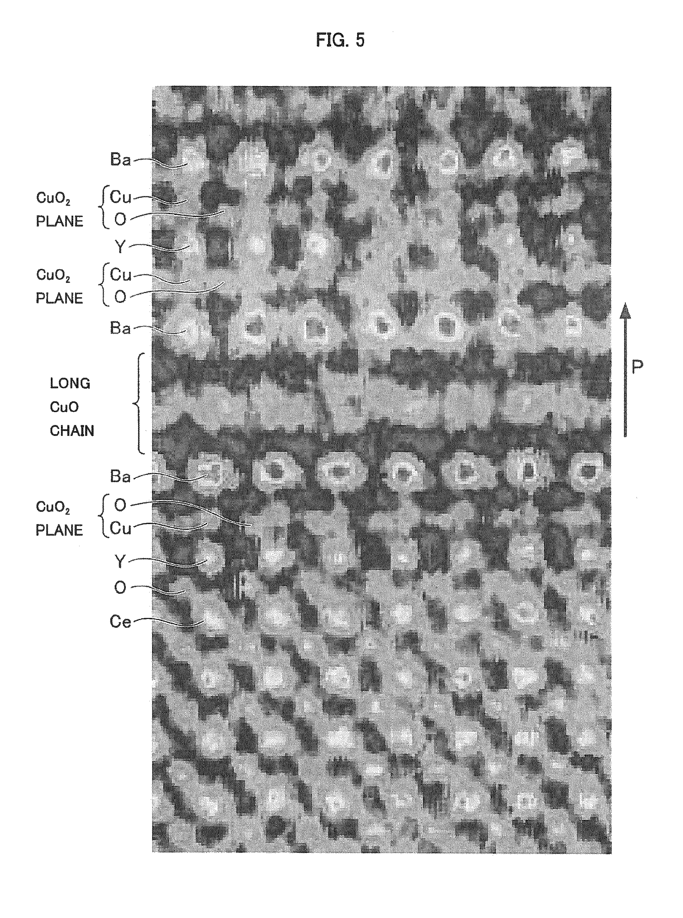

Fig. 5 is a diagram showing an ABF image of, in particular, the interface between an intermediate layer (CeO₂ layer) and a superconducting layer (YBCO layer) in a cross-section in the layering direction P of an oxide superconducting thin film of a thin-film type superconducting element according to Example 1.

As shown in Fig. 5, a CuO single chain at the center in the layering direction P in the figure, i.e., a CuO single chain of the first layer of the RE-based superconductor unit (one unit lattice of YBCO) from the intermediate layer side in the layering direction P was confirmed to be longer in the layering direction than a usual CuO single chain.
In particular, while the length of the CuO single chain in the case that the length is determined by the lattice constant of the RE-based superconductor unit is usually 4.3 Å, the length of the CuO single chain of the RE-based superconductor unit in the Example was confirmed to be elongated to 7.9 Å (about twice) in the layering direction P. In the Example, the "layering direction" can be regarded as being equivalent to the "c-axis direction" of the RE-based superconductor unit.
When the CuO single chain elongated in the layering direction P is in the superconducting layer in such a manner, the lattice strain between the intermediate layer and the superconducting layer can be alleviated and a crack of the layer due to thermal shrinkage becomes to hardly occur, whereby a film can be made thick.

The first layer of YBCO which grows on the intermediate layer (CeO₂ layer) starts at the layer of Y. Namely, it was confirmed that the layering of the RE-based superconductor unit of the first layer was started from the rare earth element Y. This is considered to enhance the binding force with CeO₂.
Further, it was also confirmed that the oxygen ion on the CuO₂ plane of the RE-based superconductor unit of the first layer (in the figure, oxygen ion on the CuO₂ plane under the long CuO single chain) was positioned so as to be shifted from the half unit cell position of the RE-based superconductor unit by in the range between 1/8 and 1/2.
Still further, it was confirmed that the RE-based superconductor units sandwiching the long CuO single chain in the layering direction shifted by 1/8 to 1/2 of the RE-based superconductor unit in the ab plane direction.

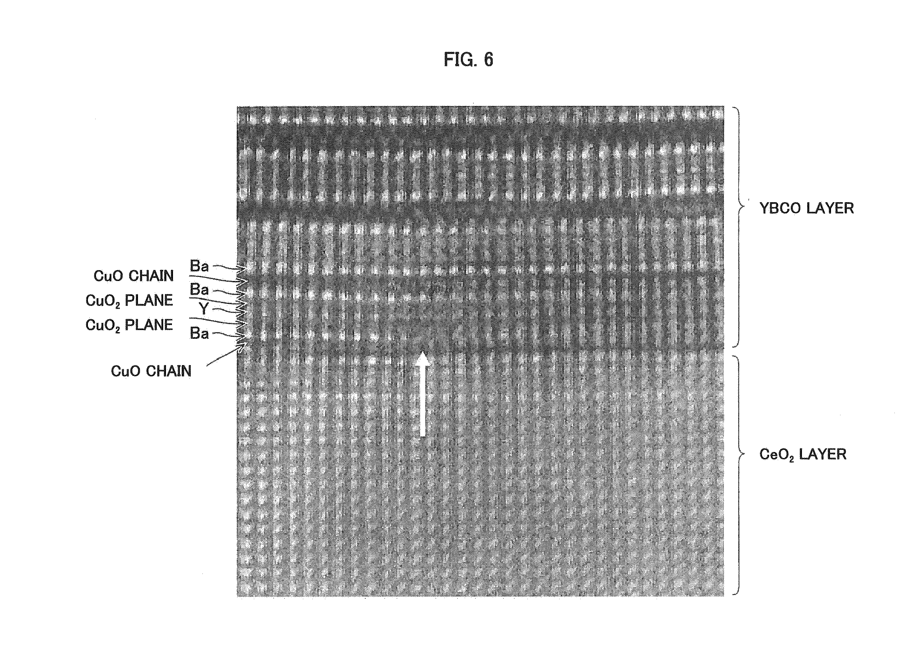

Fig. 6 is a diagram showing another ABF image of, in particular, the interface between an intermediate layer (CeO₂ layer) and a superconducting layer (YBCO layer) in a cross-section in the layering direction P of the oxide superconducting thin film of the thin-film type superconducting element of Example 1 which is at a position different from that in Fig. 5.

As shown in Fig. 6, an edge dislocation was confirmed at the portion of an white arrow (discontinuous portion in which the number of lattices of the YBCO decreases compared to the number of lattices of the CeO₂ below) at the interface between the intermediate layer (CeO₂ layer) and the superconducting layer (YBCO layer).
When an edge dislocation like this is present, the number of lattices of the YBCO of the superconducting layer decreases with respect to the CeO₂ of the intermediate layer, which alleviates the lattice mismatch between the intermediate layer and the superconducting layer. By this, a structure that is unlikely to crack due to thermal shrinkage is obtained, whereby a film can be made thick.

A thin-film type superconducting element including an RE-based superconductor unit in which the length of the CuO single chain differed as shown in Table 1 was formed by changing the sintering environment of the superconducting layer 13 and the intermediate layer 12 (inert atmosphere) and the sintering temperature to adjust the width of the CuO single chain in the manufacturing method of the above-mentioned Example 1. In this case, the length of the CuO chain determined by the lattice constant for comparison was 4.3 Å.

For the interlayer binding force between the CeO₂ layer and the YBCO layer and the orientation of the superconducting layer of the obtained thin-film type superconducting element, evaluations were performed as follows.

### ·Evaluation of interlayer binding force between CeO₂ layer and YBCO layer

With respect to the interlayer binding force between the CeO₂ layer and the YBCO layer, an evaluation was performed by Madelung energy. Specifically, from the interatomic distance which can be read by TEM, the Madelung energy of an atom on the CuO₂ plane was determined and the energy from the CuO chain side and the energy from the RE ion side were evaluated. For the obtained values, an evaluation was performed by the following criteria.
A: the energy on the RE ion side is two times or higher the energy on the CuO chain side.
B: the energy on the RE ion side is equal to to two times the energy on the CuO chain side.
C: the energy on the RE ion side is equal to or smaller than the energy on the CuO chain side.

### · Orientation of superconducting layer

For the orientation of the superconducting layer, a value of the half width of a YBCO 006 peak was measured by XRD measurement and, for the obtained values, an evaluation was performed by the following criteria.
A: 0.2 degrees or lower
B: 0.2 degrees to 0.5 degrees
C: 0.5 degrees or higher

### · Performance of superconducting layer

The performance of the superconducting layer was measured by the critical current density and evaluated by the following criteria.
A: 3 MA/cm² or higher
B: higher than 2 MA/cm² to less than 3 MA/cm²
C: 2 MA/cm² or less

**Table 1**

| Length ratio of CuO single chain | Binding force | Orientation of superconducting layer | Performance of superconducting layer |
|---|---|---|---|
| 1.0 | C | A | C |
| 1.1 | C | A | C |
| 1.2 | B | A | A |
| 1.3 | B | A | A |
| 1.6 | A | B | B |
| 1.8 | A | B | B |
| 2.0 | A | B | B |
| 2.1 | A | C | C |
| 2.3 | A | C | C |

As is understood from Table 1, it was found that when the length of the long CuO single chain in the layering direction P was less than 1.2 times the length of the CuO single chain determined by the lattice constant of the RE-based superconductor unit, the interlayer binding force between the CeO₂ layer and the YBCO layer was large and the performance of the superconducting layer was low. It was also found that the length of the long CuO single chain in the layering direction P was more than 2 times the length of the CuO single chain determined by the lattice constant of the RE-based superconductor unit, the orientation of the superconducting layer was low.

On the other hand, it was found that when the length of the long CuO single chain in the layering direction P was 1.2 times to 2 times the length of the CuO single chain determined by the lattice constant of the RE-based superconductor unit, the interlayer binding force between the CeO₂ layer and the YBCO layer was low and the orientation of the superconducting layer was high, and therefore the performance of the superconducting layer was high.
It was also found that when the length of the long CuO single chain in the layering direction P was 1.2 times to 1.3 times the length of the CuO single chain determined by the lattice constant of the RE-based superconductor unit, the performance of the superconducting layer was high.

### -Example 2-

In Example 2, a thin-film type superconducting element in which a superconducting layer was provided with an oxide superconducting thin film in which a normal YBCO (Y-123), a superlattice structure thereof (including a simple stacking fault and a modulated structure), and the like was manufactured.
In the manufacturing of a thin-film type superconducting element, firstly, a sapphire substrate in which the r-plane direction of the sapphire single crystal is the main surface was prepared. Next, the sapphire substrate was subjected to pre-annealing at 1000°C.
Next, by using an electron beam deposition method, in a state in which a plasma was generated in 3 × 10⁻² Pa oxygenand the sapphire substrate was heated up to 750°C, CeO₂ was deposited on the cut surface of the sapphire substrate about 20 nm to form an intermediate layer. Next, the substrate was subjected to post-annealing at 800°C to perform a surface treatment (flattening and regulation of the valence) of the intermediate layer.
Next, a solution of organic complexes of yttrium, barium and copper was applied on the surface of the intermediate layer with a spin coater, and presintering was performed at 500°C in the air. Then, sintering was performed by raising the temperature up to 800°C in an oxygen atmosphere at 10 ppm to 100 ppm, and the oxygen atmosphere was switched to an 100% oxygen atmosphere at the time of lowering the temperature. By this, a superconducting layer composed of YBCO which have been well oxygen annealed and has good properties was formed. By way of the above-mentioned manufacturing process, an oxide superconducting thin film was manufactured.
A gold-silver alloy was deposited on the obtained oxide superconducting thin film by sputtering and an electrode was attached thereto, whereby a thin-film type superconducting element of Example 2 was manufactured.

Although the thin-film type superconducting element was in a superconducting state by cooling to the liquid nitrogen temperature, when a certain amount of electric current flowed, the element was in a normal conducting state, thereby enabling current limiting.

### <TEM evaluation>

The obtained thin-film type superconducting element was processed and, by using a TEM, plural ABF images of an superconducting layer in the thin-film type superconducting element were observed. In the ABF images, structures in which a perovskite layer having a CuO plane which serves a function of supercurrent and a CuO chain were layered can be observed. Among the structures, those having a single CuO chain, those having a double CuO chain and those having CuO chains modulated from a single to a double along the way were observed.
Specifically, the following result was obtained.

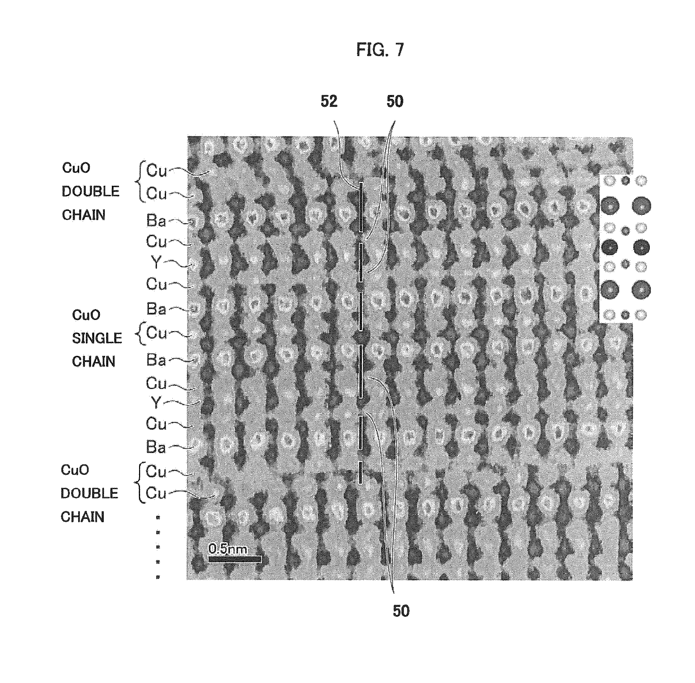

Fig. 7 is a diagram showing an ABF image of a partial region of the superconducting layer in the thin-film type superconducting element of Example 2.

As shown in Fig. 7, it was confirmed that, in a partial region of the superconducting layer, a CuO single chain and a CuO double chain existed alternatively in the c-axis direction. It was also confirmed that the oxygen ion 30 on the CuO₂ plane sandwiched between a CuO single chain and a CuO double chain in the c-axis direction displaced (shifted) from the half unit cell position 32 in the ab plane direction by about 1/8 interval of one unit cell.
Since the CuO₂ plane serves a function of transportation of supercurrent, it is thought that the shift of the oxygen ion 30 at the portion has a great influence on the superconducting properties and the oxygen ion 30 can be a pinning center. Due to the field of the view, in Fig. 7, a CuO single chain and a CuO double chain existed alternatively. Other regions were observed in the same manner, and a portion in which CuO single chains or CuO double chains existed in the c-axis direction continuously and, a portion in which a CuO single chain and a CuO double chain exist alternatively as in Fig. 7 were confirmed.

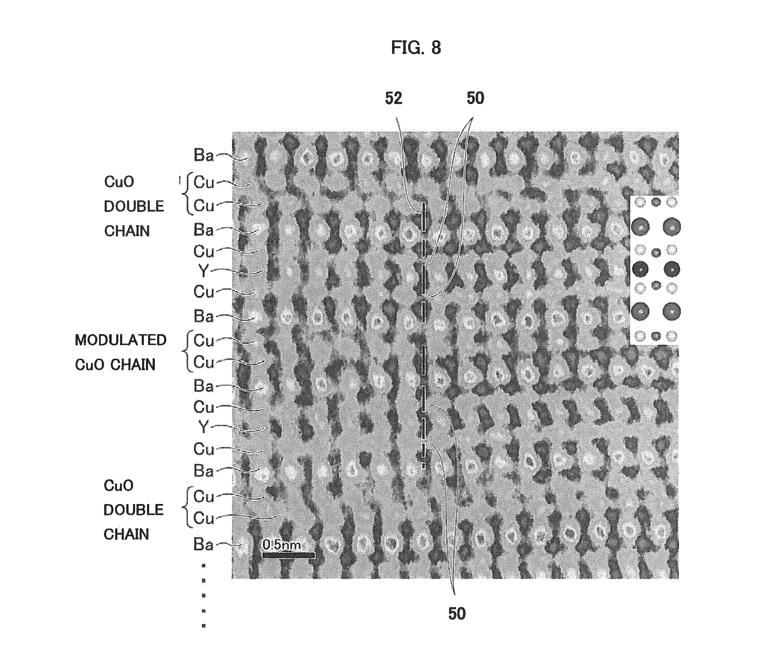

Fig. 8 is a diagram showing an ABF image of another partial region of the superconducting layer in the thin-film type superconducting element of Example 2.

As shown in Fig. 8, in another partial region of the superconducting layer in the c-axis direction, a modulated layer (modulated CuO chain in the figure) in which the CuO single chain 24 and the CuO double chain 26 were mixed in the ab plane direction was confirmed. It was also confirmed that the position of the oxygen ion 30 on the CuO₂ plane adjacent to the modulated layer, i.e., the CuO₂ plane sandwiched between the modulated layer and the CuO double chain 26 displaced (shifted) from the half unit cell position 32 in the ab plane direction by about 1/8 interval of a unit cell. In the same manner as in Fig. 7, it is shown that the oxygen ion 30 can be a pinning center. Due to the field of the view, in Fig. 8, a modulated CuO chain and a CuO double chain existed alternatively. Other regions were observed in the same manner, and a portion in which CuO single chains or CuO double chains existed in the c-axis direction continuously and, a portion in which a modulated CuO single chain and a CuO double chain exist alternatively as in Fig. 8 were confirmed.
Comparing the oxygen ion 30 shown in Fig. 7 and the oxygen ion 30 shown in Fig. 8, it is found that the position of the oxygen ion 30 shown in Fig. 8 is more shifted from the half unit cell position 32 in the ab plane direction.

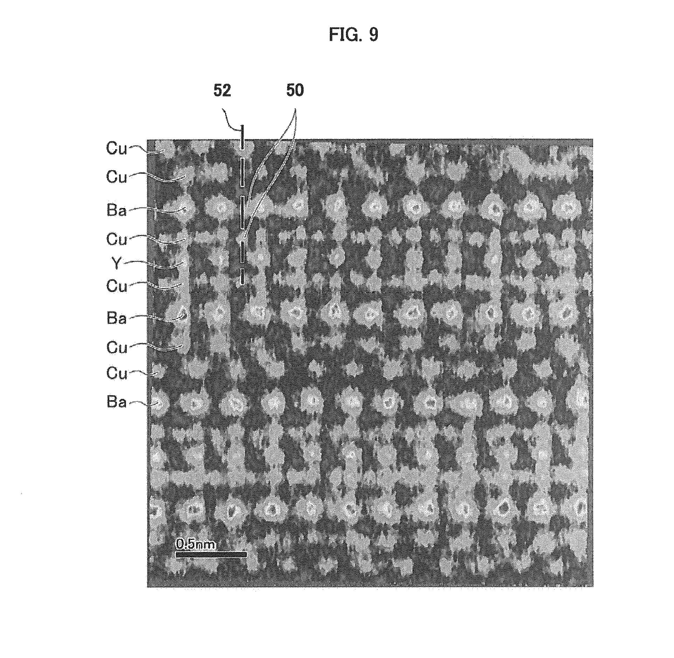

Fig. 9 is a diagram showing an ABF image of another partial region of the superconducting layer in a thin-film type superconducting element of Example 2.

As shown in Fig. 9, it was confirmed that, in another partial region of the superconducting layer, of the CuO chains, only the CuO double chain 26 existed in the c-axis direction. In the c-axis direction, the oxygen ion 30 on the CuO₂ plane sandwiched between the CuO double chains 26 was positioned at the half unit cell position 32 and not shifted in the ab plane direction.

Accordingly, it was found that, in the superconducting layer of the thin-film type superconducting element of Example 2, a region in which the oxygen ion 30 on the CuO₂ plane shifted existed and that not only the stacking fault but also a shift of the oxygen ion 30 on the CuO₂ plane was effective as a pinning center.

### - Example 3 and Comparative Example 1 -

Next, for Example 3, a thin-film type superconducting element having good critical current properties (Jc ≈ 3 MA/cm³) was prepared, and for Comparative Example 1, a thin-film type superconducting element having poor critical current properties (Jc ≈ 1 MA/cm³) was prepared. In the manufacturing of Example 3, after forming an intermediate layer, annealing was performed at 800°C and then a YBCO was formed. On the other hand, in the manufacturing in Comparative Example 1 a YBCO was formed without performing annealing after forming an intermediate layer.
Regarding the critical current properties Jc, by using Cryoscan manufactured by THEVA, the critical current density (Jc) distribution of the thin-film type superconducting element at the liquid nitrogen temperature was measured by an induction method, and the highest in the distribution was evaluated.

For the thin-film type superconducting element of Example 3 and the thin-film type superconducting element of Comparative Example 1, an ABF image of each superconducting layer was observed by TEM.
As the result, in the thin-film type superconducting element of Example 3, a CuO chain and a CuO double chain existed in a dispersed state in the superconducting layer. Many portions having a modulated structure were seen. The oxygen ion 30 on the CuO₂ plane adjacent to the CuO single chain and the CuO double chain was confirmed to be shifted from the half unit cell position in the ab plane direction.
On the other hand, in the thin-film type superconducting element in Comparative Example 1, a CuO single chain and a CuO double chain existed in a dispersed state in the superconducting layer. Portions having a modulated structure were seen but not so many thereof were seen. The oxygen ion 30 on the CuO₂ plane adjacent to the CuO single chain and the CuO double chain was also confirmed to be partially shifted from the half unit cell position in the ab plane direction. It was not confirmed, however, that the CuO single chains or the CuO double chains existed continuously in the c-axis direction.
Accordingly, it can be said that the critical current properties correlate with the shift of the oxygen ion 30 on the CuO₂ plane.

## Claims

1. An oxide superconducting thin film, comprising:
a base material;
a superconducting layer formed on the base material and comprising a plurality of RE-based superconductor units comprising a rare earth element, CuO chains, and CuO₂ planes;
among the CuO chains, CuO chains that are present in the RE-based superconductor units in the vicinity of an interface between the superconducting layer and a layer adjacent to the base material side of the superconducting layer, and that are from 1.2 to 2 times longer in a layering direction than a length of the CuO chains determined according to a lattice constant of the RE-based superconductor units; and
an edge dislocation that is present adjacent to the long CuO chain with respect to the layering direction.

2. The oxide superconducting thin film according to claim 1, comprising an intermediate layer that is disposed between the base material and the superconducting layer and that comprises another rare earth element capable of having the same valence as the rare earth element.

3. The oxide superconducting thin film according to claim 1 or 2, wherein the long CuO chains are present in the RE-based superconductor units that are in a first layer or a second layer from the interface between the superconducting layer and the layer adjacent to the base material side of the superconducting layer.

4. The oxide superconducting thin film according to claim 3, wherein the RE-based superconductor unit in the first layer is layered from the rare earth element.

5. The oxide superconducting thin film according to any one of claims 2 to 4, wherein the RE-based superconductor units sandwiching the long CuO chain in the layering direction are displaced from each other in an ab plane direction by 1/8 to 1/2 of the RE-based superconductor unit.

6. The oxide superconducting thin film according to any one of claims 2 to 5, wherein at least a layer on the superconducting layer side in the intermediate layer is formed of CeO₂ or REMnO₃.

7. An oxide superconducting thin film formed on a base material and comprising an RE-based superconductor as a main component,
wherein the RE-based superconductor comprises CuO₂ planes, CuO single chains and CuO double chains, and further comprises a heterologous chain portion in which a CuO single chain and a CuO double chain are adjacent, and a homologous chain portion in which the CuO single chains are adjacent to each other or the CuO double chains are adjacent to each other.

8. The oxide superconducting thin film according to claim 7, wherein the heterologous chain portion is 1/4 times to 4 times the homologous chain portion.

9. The oxide superconducting thin film according to claim 7 or 8, wherein an oxygen ion of a CuO₂ plane adjacent to the CuO single chain and the CuO double chain is positioned so as to be shifted from a mid-point between nearest neighboring Cu's on the adjacent CuO₂ plane by 1/8 to less than 1/2 of one unit cell of the RE-based superconductor in an ab plane direction of the RE-based superconductor.

10. The oxide superconducting thin film according to any one of claims 7 to 9, comprising a structure in which the heterologous chain portion and the homologous chain portion are present in a mixed manner in a c-axis direction of the RE-based superconductor.

11. The oxide superconducting thin film according to any one of claims 7 to 10, comprising a modulated structure having a modulated layer in which the heterologous chain portion and the homologous chain portion are present in a mixed manner in the ab plane direction of the RE-based superconductor.
